# EUROPÄISCHE PATENTSCHRIFT

(11) **EP 4 430 661 B1**
(45) Veröffentlichungstag und Bekanntmachung des Hinweises auf die Patenterteilung: **12.11.2025**
(21) Anmeldenummer: 22822153.7
(22) Anmeldetag: 28.11.2022
(51) Int. Cl.: H01L 23/373, H01L 23/34, H01L 23/498, H05K 1/03, H05K 3/34

(54) **ANORDNUNG FÜR EINE HALBLEITERANORDNUNG MIT MINDESTENS EINEM PASSIVEN BAUELEMENT UND EINEM SUBSTRAT**
ARRANGEMENT FOR A SEMICONDUCTOR DEVICE COMPRISING AT LEAST ONE PASSIVE COMPONENT AND A SUBSTRATE
AGENCEMENT POUR UN DISPOSITIF À SEMI-CONDUCTEUR POURVU D'AU MOINS UN COMPOSANT PASSIF ET D'UN SUBSTRAT

(30) Priorität: 01.02.2022 EP 22154511
(43) Veröffentlichungstag der Anmeldung: 18.09.2024
(73) Patentinhaber: Siemens Aktiengesellschaft, 80333 München (DE)
(72) Erfinder: LASCH, Markus, 81927 München (DE); LORZ, Roland, 91341 Röttenbach (DE); PFEIFER, Markus, 90455 Nürnberg (DE); STEGMEIER, Stefan, 81825 München (DE); WEISBROD, Erik, 81369 München (DE); WERNER, Ronny, 90429 Nürnberg (DE); ZEYSS, Felix, 91052 Erlangen (DE)
(74) Vertreter: Siemens Patent Attorneys
(86) Internationale Anmeldenummer: PCT/EP2022/083400
(87) Internationale Veröffentlichungsnummer: WO 2023/147910

(56) Entgegenhaltungen:
- EP-B1- 2 578 068
- US-A1- 2015 163 916
- US-A1- 2016 007 486

## Beschreibung

Die Erfindung betrifft eine Anordnung für eine Halbleiteranordnung mit mindestens einem passiven Bauelement und einem Substrat, wobei das Substrat eine dielektrische Materiallage und eine auf der dielektrische Materiallage angeordnete erste Metallisierung aufweist.

Ferner betrifft die Erfindung eine Halbleiteranordnung, insbesondere eine planare Halbleiteranordnung, mit mindestens einer derartigen Anordnung.

Überdies betrifft die Erfindung einen Stromrichter mit mindestens einer Halbleiteranordnung.

Darüber hinaus betrifft die Erfindung ein Verfahren zur Herstellung einer Anordnung für eine Halbleiteranordnung mit mindestens einem passiven Bauelement und einem Substrat, wobei das Substrat eine dielektrische Materiallage und eine auf der dielektrischen Materiallage angeordnete erste Metallisierung aufweist.

Derartige Anordnungen kommen beispielsweise in einem Stromrichter zum Einsatz. Unter einem Stromrichter ist beispielsweise ein Gleichrichter, ein Wechselrichter, ein Umrichter oder ein Gleichspannungswandler zu verstehen. In einem Stromrichter können Bauelemente wie Kondensatoren, Snubber aber auch Sensoren, unter anderem zur Ermittlung von Strömen, Spannungen oder Temperaturen, zum Einsatz kommen, die üblicherweise auf einem Substrat aufgelötet sind. Derartige Sensoren können beispielsweise einen Strommesswiderstand, einen sogenannten Shunt-Widerstand oder einen Negative Temperature Coefficient Thermistor, kurz NTC, umfassen. Die Bauteile können teilweise, z.B. um genaue Messergebnisse zu erzielen, in einen stromführenden Pfad oder im Bereich einer Wärmequelle angeordnet werden, wobei eine ausreichende Entwärmung zu gewährleisten ist. Ferner stellen mit zunehmender Miniaturisierung der Bauraum und die Lebensdauer eine große Herausforderung dar.

Die Offenlegungsschrift EP 3 625 823 A1 beschreibt ein Leistungsmodul mit mindestens einem Leistungshalbleiter, insbesondere einem Leistungstransistor, welcher eine erste Kontaktfläche und eine der ersten Kontaktfläche gegenüberliegende zweite Kontaktfläche aufweist, und einem Substrat, welches zumindest zwei übereinander angeordnete miteinander verbundene Lagen umfasst. Um eine, im Vergleich zum Stand der Technik, höhere Beständigkeit gegenüber Feuchtigkeit zu erreichen und eine niederinduktive planare Anbindung des mindestens einen Leistungshalbleiters zu ermöglichen, wird vorgeschlagen, dass die erste Lage ein erstes dielektrisches Material mit zumindest einer ersten Metallisierung umfasst, wobei die erste Metallisierung auf einer der zweiten Lage zugewandten Seite angeordnet ist, wobei die zweite Lage ein zweites dielektrisches Material mit zumindest einer zweiten Metallisierung umfasst, wobei die zweite Metallisierung auf einer der ersten Metallisierung abgewandten Seite angeordnet ist, wobei der Leistungshalbleiter über die erste Kontaktfläche mit der ersten Metallisierung verbunden ist, wobei der Leistungshalbleiter in einer ersten Aussparung der zweiten Lage angeordnet ist, wobei eine metallische erste Kapselung derartig angeordnet ist, dass der Leistungshalbleiter fluiddicht gekapselt ist und die zweite Kontaktfläche des Leistungshalbleiters über die erste Kapselung elektrisch leitend mit der zweiten Metallisierung verbunden ist.

Die Offenlegungsschrift WO 2020/249479 A1 beschreibt einen elektronischen Schaltkreis mit einem ersten und einem zweiten Schaltungsträger sowie einem ersten und einem zweiten Halbleiterbauelement. Das erste Halbleiterbauelement liegt mit einer Oberseite an einer Unterseite des ersten Schaltungsträgers an sowie mit einer Unterseite an einer Oberseite des zweiten Schaltungsträgers. Der erste Schaltungsträger weist eine erste Durchkontaktierung auf, welche das erste Halbleiterbauelement mit einer ersten Leiterbahn verbindet. Der erste Schaltungsträger weist eine zweite Durchkontaktierung auf, welche ein zwischen den Schaltungsträgern angeordnetes Verbindungselement mit einer weiteren Leiterbahn elektrisch verbindet.

Die Offenlegungsschrift US 2015/163916 A1 beschreibt eine Vorrichtung zur Montage elektronischer Komponenten umfassend ein isolierendes Substrat mit einem darauf ausgebildeten Metallmuster und eine elektronische MELF-Komponente. Die elektronische MELF-Komponente wird in einen ersten Aufnahmeabschnitt eingepasst, der so konfiguriert ist, dass das Metallmuster und das isolierende Substrat an einem fehlenden Abschnitt des Metallmusters freiliegen.

Die Patentschrift EP 2 578 068 B1 beschreibt ein Verfahren zum Verbinden von elektrischen oder elektronischen Bauteilen, die mit elektrischen Kontakten versehen sind, mit einem Träger, der eine elektrisch leitende Schaltung aufweist. Die elektrisch leitende Schaltung wird durch Gießen eines elektrisch leitenden thermoplastischen Polymers hergestellt; ein Gehäuse wird zumindest teilweise in der elektrisch leitenden Schaltung vorgesehen; das Bauteil wird in dem Gehäuse vorpositioniert, indem die elektrischen Kontakte zumindest teilweise in Kontakt mit der elektrisch leitenden Schaltung gebracht werden; die elektrischen Kontakte des Bauteils werden in Kontakt mit der elektrisch leitenden Schaltung gebracht; und zumindest das Bauteil wird einer Ultraschallschwingung ausgesetzt, um die Kontakte des Bauteils mit der elektrisch leitenden Schaltung zu verlöten.

US 2016/007486 beschreibt ein Packagesubstrat zur Montage elektronischer Bauelemente umfassend ein Substrat und eine Metallschicht, die zwischen einem Metallpfosten und einem Metalldeckel angeordnet ist, wobei das elektronische Bauelement in einer durch den Metallpfosten gebildeten Kavität montiert ist.

Vor diesem Hintergrund ist es eine Aufgabe der vorliegenden Erfindung, den Bauraum einer derartigen Anordnung zu verringern und eine verbesserte Entwärmung zu ermöglichen.

Diese Aufgabe wird bei einer Anordnung eingangs genannter Art dadurch gelöst, dass das passive Bauelement vollständig in einer Aussparung der ersten Metallisierung angeordnet ist und unmittelbar auf der dielektrischen Materiallage aufliegt.

Ferner wird die Aufgabe erfindungsgemäß gelöst durch eine Halbleiteranordnung, insbesondere eine planare Halbleiteranordnung, mit mindestens einer derartigen Anordnung.

Überdies wird die Aufgabe erfindungsgemäß gelöst durch einen Stromrichter mit mindestens einer Halbleiteranordnung.

Darüber hinaus wird die Aufgabe bei einem Verfahren eingangs genannter Art dadurch gelöst, dass das passive Bauelement vollständig und derartig in einer Aussparung der ersten Metallisierung angeordnet wird, dass das passive Bauelement unmittelbar auf der dielektrischen Materiallage aufliegt.

Die in Bezug auf die Anordnung nachstehend angeführten Vorteile und bevorzugten Ausgestaltungen lassen sich sinngemäß auf die Halbleiteranordnung, den Stromrichter und das Verfahren übertragen.

Der Erfindung liegt die Überlegung zugrunde, den Bauraum mindestens eines passiven Bauelements in einer Anordnung für eine Halbleiteranordnung zu verringern, indem dieses vollständig in einer Aussparung einer ersten Metallisierung eines Substrats angeordnet wird. Eine Aussparung ist in diesem Zusammenhang eine durchgängige Ausnehmung der ersten Metallisierung. Diese durchgängige Ausnehmung kann unter anderem eine rechteckige Außenkontur aufweisen. Eine Halbleiteranordnung kann unter anderem ein Leistungshalbleitermodul sein. Ein derartiges, insbesondere zumindest teilweise metallisches, passives Bauelement kann unter anderem als Widerstandssensor, insbesondere als Shunt-Widerstand oder als NTC ausgeführt sein. Beispielsweise ist ein derartiger Widerstandssensor zumindest teilweise aus einer Legierung hergestellt, welche unter anderem Zeranin, Manganin, Konstantan, Isaohm oder einen Kaltleiter wie Platin enthalten kann. Die erste Metallisierung des Substrats kann beispielsweise Kupfer, Silber oder Gold enthalten. Durch eine derartige Integration des passiven Bauelements in die erste Metallisierung wird Bauraum, insbesondere in vertikale Richtung, eingespart.

Um eine ausreichende thermische Anbindung und damit eine effiziente Entwärmung des mindestens einen passiven Bauelements zu ermöglichen, liegt dieses unmittelbar, das heißt ohne weitere Verbindungsmittel, auf der dielektrischen Materiallage des Substrats auf. Die dielektrische Materiallage kann unter anderem einen keramischen Werkstoff, beispielsweise Aluminiumnitrid oder Aluminiumoxid, oder einen organischen Werkstoff, beispielsweise ein Polyamid oder Epoxidharz, enthalten. Insbesondere ist das, beispielsweise im wesentlichen quaderförmige, passive Bauelement vollflächig an die dielektrische Materiallage angebunden. Durch eine derartige Anbindung neben einer verbesserten Entwärmung zusätzlich Bauraum eingespart, da, unter anderem, weitere Bauteile näher am passiven Bauelement platzierbar sind. Ferner wird durch die Integration des mindestens einen passiven Bauelements das Herstellungsverfahren vereinfacht, da ein Bestückprozess und ein Auflöten entfällt.

Das passive Bauelement weist eine erste Profilierung und die erste Metallisierung weist im Bereich der Kontaktierung mit dem passiven Bauelement eine zweite Profilierung auf, wobei die Profilierungen miteinander im Eingriff stehen. Beispielsweise weist die erste Metallisierung eine Ausnehmung, insbesondere ein Falz oder/oder eine Fase auf, welche mit einem zumindest teilweise korrespondierenden Überstand des passiven Bauelements in Eingriff steht, wodurch ein Formschluss ausgebildet wird. Durch einen derartigen Formschluss wird die Zuverlässigkeit der Verbindung erhöht.

Eine weitere Ausführungsform sieht vor, dass das passive Bauelement bündig mit einer ersten Oberfläche der ersten Metallisierung abschließt. Durch einen derartigen bündigen Abschluss wird ein Anpressen der ersten Metallisierung mit dem passive Bauelement erleichtert, sodass das passive Bauelement zuverlässig vollflächig mit der dielektrischen Materiallage kontaktierbar ist.

Eine weitere Ausführungsform sieht vor, dass die erste Metallisierung als Dickkupfersubstrat ausgeführt ist, wobei das passive Bauelement zwischen zwei Seiten des Dickkupfersubstrats vollflächig mit der dielektrischen Materiallage verpresst ist. Ein derartiges Dickkupfersubstrat weist eine Kupferdicke von mindestens 1 mm auf. Eine derartige Verbindung ist robust und einfach herstellbar.

Eine weitere Ausführungsform sieht vor, dass das passive Bauelement unmittelbar oder über Verbindungsmittel in der Aussparung der ersten Metallisierung verbunden ist. Eine unmittelbare Verbindung ist beispielsweise durch direktes Verpressen oder durch eine Schrumpfverbindung herstellbar. Mittels der Verbindungsmittel wird beispielsweise eine Pressfit-Verbindung hergestellt, über welche das das passiven Bauelement mit der ersten Metallisierung verbunden wird. Derartige kraftschlüssige Verbindungen sind robust und einfach herstellbar.

Eine weitere Ausführungsform sieht vor, dass das passive Bauelement aus einem ersten Werkstoff hergestellt ist, wobei die Verbindungsmittel einen zweiten Werkstoff enthalten, welcher sich vom ersten Werkstoff zumindest hinsichtlich seiner mechanischen und/oder thermischen Eigenschaften unterscheidet. Verbindungsmittel können beispielsweise Zinnplättchen oder eine Beschichtung des passiven Bauelements sein, welche beispielsweise Kupfer-Zinn (Cu-Sn), Kupfer-Nickel-Silizium (Cu-Ni-Si) oder Kupfer-Chrom-Silber (Cu-Cr-Ag) enthält. Durch unterschiedliche mechanische und/oder thermische Eigenschaften, wie Ausdehnungskoeffizient und/oder Elastizitätsmodul, werden beispielsweise während des Betriebes auftretende thermische Verspannungen verringert. Alternativ ist über die Verbindungsmittel eine stoffschlüssige Verbindung zwischen dem passiven Bauelement und der ersten Metallisierung herstellbar.

Beispielsweise wird ein Zinnplättchen zur Herstellung einer stoffschlüssigen Verbindung geschmolzen. Derartige Verbindungen tragen durch Reduzierung von, insbesondere thermischen, Verspannungen, zu einer Verlängerung einer Lebensdauer der Anordnung bei.

Eine weitere Ausführungsform sieht vor, dass das passive Bauelement über eine durch die formschlüssige Verbindung senkrecht zur ersten Oberfläche wirkende Kraft mit der dielektrischen Materiallage verbunden ist. Durch eine derartige Verbindung werden auf das passive Bauelement wirkende Verspannungen reduziert.

Eine weitere Ausführungsform sieht vor, dass das Substrat eine zweite Metallisierung aufweist, welche als Dickkupfersubstrat ausgeführt ist, wobei die dielektrische Materiallage auf die zweite Metallisierung laminiert oder mit der zweiten Metallisierung verpresst ist, wobei die zweite Metallisierung über die dielektrische Materiallage mit der ersten Metallisierung verbunden ist. Durch ein derartiges Herstellungsverfahren wird die Herstellung einer sehr dünnen Substratlage ermöglicht, was eine Wärmeabfuhr über die zweite Metallisierung verbessert.

Eine weitere Ausführungsform sieht vor, dass das passive Bauelement als Sensor ausgeführt ist und die Anordnung zumindest einen Anschluss zur Kontaktierung des Sensors umfasst. Beispielsweise ist der Sensor als Shunt-Widerstand ausgeführt, welcher Zeranin, Manganin, Konstantan, Isaohm enthält. Eine Integration eines derartigen Shunt-Widerstands verbessert die thermische Anbindung, sodass eine hohe Messgenauigkeit und lange Lebensdauer erzielbar sind. Alternativ kann der Sensor als Temperatursensor, z.B. als NTC, ausgeführt sein, welcher einen Kaltleiter, insbesondere Platin, enthält. Durch eine Verbesserung der thermischen Anbindung an die Umgebung über das Substrat wird eine genaue Temperaturerfassung ermöglicht. Im Folgenden wird die Erfindung anhand der in den Figuren dargestellten Ausführungsbeispiele näher beschrieben und erläutert.

Es zeigen:
- FIG 1: eine schematische Querschnittsdarstellung eines ersten nicht erfindungsgemäßen Beispiels einer Anordnung mit einem passiven Bauelement und einem Substrat,
- FIG 2: eine schematische Querschnittsdarstellung eines zweiten nicht erfindungsgemäßen Beispiels einer Anordnung mit einem passiven Bauelement und einem Substrat,
- FIG 3: eine schematische Querschnittsdarstellung eines dritten nicht erfindungsgemäßen Beispiels einer Anordnung mit einem passiven Bauelement und einem Substrat,
- FIG 4: eine schematische Querschnittsdarstellung eines vierten nicht erfindungsgemäßen Beispiels einer Anordnung mit einem passiven Bauelement und einem Substrat,
- FIG 5: eine schematische Querschnittsdarstellung einer Ausführungsform einer Anordnung mit einem passiven Bauelement und einem Substrat,
- FIG 6: eine schematische Darstellung eines nicht erfindungsgemäßen Beispiels einer Anordnung mit einem passiven Bauelement und einem Substrat in einer Draufsicht,
- FIG 7: eine schematische Darstellung eines Ausschnitts eines nicht erfindungsgemäßen Beispiels einer Anordnung mit einem passiven Bauelement und einem Substrat in einer Draufsicht,
- FIG 8: eine schematische Darstellung eines nicht erfindungsgemäßen Beispiels eines ersten Verfahrens zur Herstellung einer Anordnung mit einem passiven Bauelement und einem Substrat,
- FIG 9: eine schematische Darstellung eines zweiten Verfahrens zur Herstellung einer Anordnung mit einem passiven Bauelement und einem Substrat,
- FIG 10: eine schematische Darstellung eines nicht erfindungsgemäßen Beispiels eines dritten Verfahrens zur Herstellung einer Anordnung mit einem passiven Bauelement und einem Substrat,
- FIG 11: eine schematische Querschnittsdarstellung einer Halbleiteranordnung und
- FIG 12: eine schematische Darstellung eines Stromrichters.

Gleiche Bezugszeichen haben in den verschiedenen Figuren die gleiche Bedeutung.

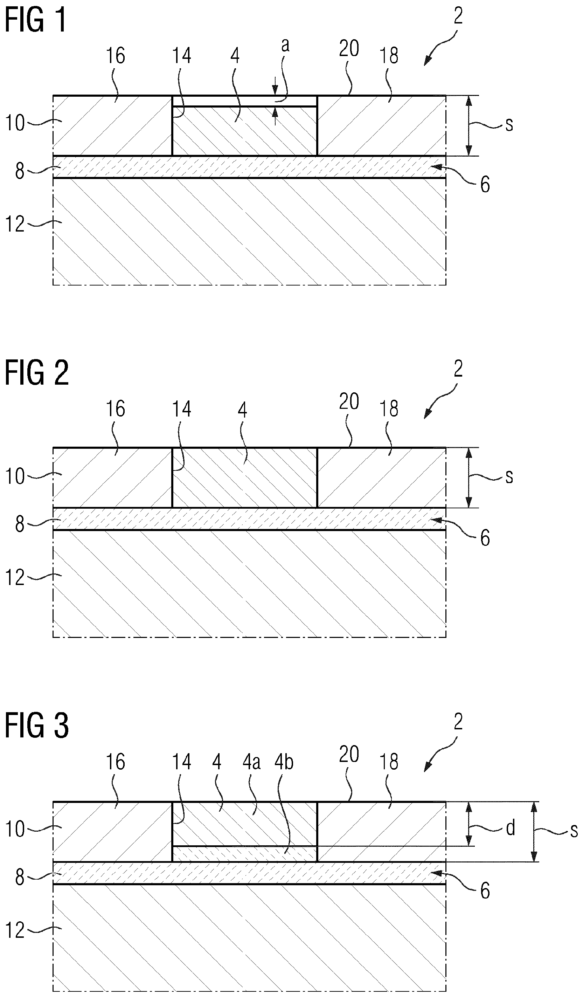

FIG 1 zeigt eine schematische Querschnittsdarstellung eines ersten Beispiels einer Anordnung 2 mit einem passiven Bauelement 4 und einem Substrat 6. Das Substrat 6 umfasst eine dielektrische Materiallage 8, welche zwischen einer ersten Metallisierung 10 und einer zweiten Metallisierung 12 angeordnet ist, wobei die erste Metallisierung 10 über die dielektrische Materiallage 8 mit der zweiten Metallisierung 12 elektrisch isolierend und thermisch leitend verbunden ist. Die dielektrische Materiallage 8 kann unter anderem einen keramischen Werkstoff, beispielsweise Aluminiumnitrid oder Aluminiumoxid, einen organischen Werkstoff, beispielsweise ein Polyamid, oder einen mit einem keramischen Werkstoff gefüllten organischen Werkstoff, enthalten. Die erste Metallisierung 10 und die zweite Metallisierung 12 sind beispielhaft als Dickkupfersubstrat mit einer Stärke s von zumindest 1 mm ausgeführt. Die erste Metallisierung 10 weist eine bis zur Aussparung 14 auf, in welcher das passive Bauelement 4 angeordnet ist. Das passive Bauelement 4 ist vollständig in der Aussparung 14 angeordnet, das heißt es steht nicht über die Aussparung 14 hinaus. Das, insbesondere metallische, passive Bauelement 4 kann unter anderem als Widerstandssensor, insbesondere als Shunt-Widerstand oder als NTC ausgeführt sein. Beispielsweise ist ein derartiger Widerstandssensor aus einer Legierung hergestellt, welche unter anderem Zeranin, Manganin, Konstantan, Isaohm oder einen Kaltleiter wie Platin enthalten kann.

Die Aussparung 14 der ersten Metallisierung 10 ist als eine bis zur dielektrischen Materiallage 8 durchgängige Ausnehmung ausgeführt. Das passive Bauelement 4, welches in FIG 1 im Wesentlichen quaderförmig ausgeführt ist, ist unmittelbar, das heißt ohne weitere Verbindungsmittel, zwischen einer ersten Seite 16 und einer zweiten Seite 18 des Dickkupfersubstrats verbunden. Beispielsweise ist das passive Bauelement 4, insbesondere durch direktes Verpressen oder durch eine Schrumpfverbindung, kraftschlüssig mit dem Dickkupfersubstrat verbunden. Ferner ist das mit dem Dickkupfersubstrat verbundene passive Bauelement 4 vollflächig mit der dielektrischen Materiallage 8 verpresst, wobei das passive Bauelement 4 unmittelbar vollflächig auf der dielektrischen Materiallage 8 aufliegt und somit elektrisch isolierend und thermisch leitend mit der zweiten Metallisierung 12 verbunden ist. Demnach ist im passiven Bauelement 4 entstehende Wärme über die dielektrischen Materiallage 8 abführbar. Darüber hinaus ist eine gute thermische Verbindung zu benachbarten Bauelementen, wie beispielsweise einem Leistungshalbleiterbauelement, herstellbar. Ferner schließt das passive Bauelement 4 mit einem Abstand a, welcher beispielsweise im µm-Bereich liegt, unterhalb einer ersten Oberfläche 20 der ersten Metallisierung 10 ab, wobei die erste Oberfläche 20 der ersten Metallisierung 10 eine horizontale Ebene definiert. Das passive Bauelement 4 ist also in das Substrat 6 integriert angeordnet, sodass Bauraum in vertikale Richtung eingespart wird.

FIG 2 zeigt eine schematische Querschnittsdarstellung eines Beispiels einer Anordnung 2 mit einem passiven Bauelement 4 und einem Substrat 6, wobei das in der Aussparung 14 der ersten Metallisierung 10 angeordnete, insbesondere kraftschlüssig verbundene, passive Bauelement 4 bündig mit der ersten Oberfläche 20 der ersten Metallisierung 10 abschließt. Das passive Bauelement 4 ist in das Substrat 6 integriert angeordnet, wobei Bauraum in vertikale Richtung eingespart wird. Ferner wird durch das bündige Abschließen Anpressen der ersten Metallisierung 10 mit dem passive Bauelement 4 erleichtert, sodass das passive Bauelement 4 zuverlässig vollflächig mit der dielektrischen Materiallage 8 kontaktierbar ist. Das weitere Beispiel der Anordnung 2 in FIG 2 entspricht der in FIG 1.

FIG 3 zeigt eine schematische Querschnittsdarstellung eines Beispiels einer Anordnung mit einem passiven Bauelement 4 und einem Substrat 6. Das passive Bauelement 4 umfasst eine metallische Schicht 4a und eine auf einer der dielektrischen Materiallage 8 zugewandten Seite der metallischen Schicht 4a angeordnete dielektrische Schicht 4b. Die dielektrische Schicht 4b ist elektrisch isolierend ausgeführt und kann unter anderem einen organischen Werkstoff, insbesondere einen Kunststoff, oder einen keramischen Werkstoff enthalten. Durch die dielektrische Schicht 4b wird eine thermisch leitfähige Anbindung der metallischen Schicht 4a des passiven Bauelements 4 an die dielektrischen Materiallage 8 ermöglicht. Unter anderem durch Variation einer Dicke d der metallischen Schicht 4a ist ein Widerstandswert des bündig mit der ersten Oberfläche 20 der ersten Metallisierung 10 abschließenden passiven Bauelements 4 flexibel einstellbar. Das weitere Beispiel der Anordnung 2 in FIG 3 entspricht der in FIG 2.

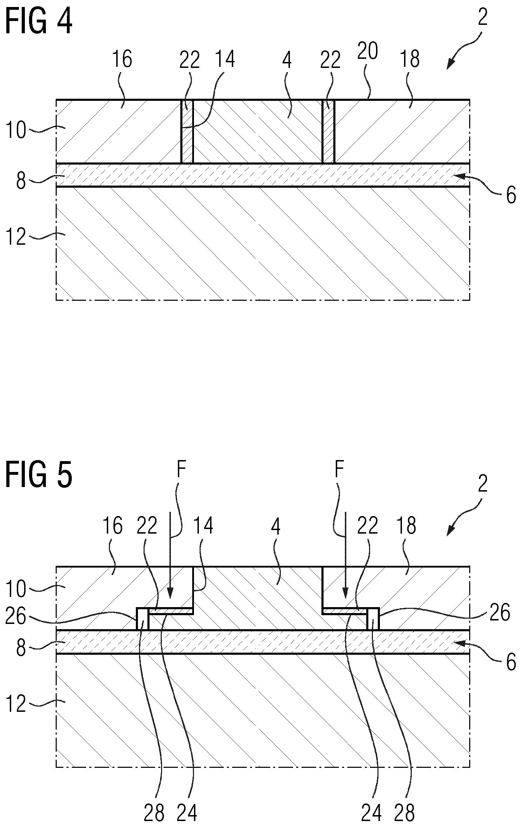

FIG 4 zeigt eine schematische Querschnittsdarstellung eines Beispiels einer Anordnung 2 mit einem passiven Bauelement 4 und einem Substrat 6, wobei das passive Bauelement 4 beidseitig über Verbindungsmittel 22 in der Aussparung 14 der ersten Metallisierung 10 verbunden ist. Die Verbindungsmittel 22 sind beispielsweise Zinnplättchen. Alternativ können die Verbindungsmittel 22 eine Beschichtung, insbesondere des passiven Bauelements 4, sein, welche beispielsweise Kupfer-Zinn (Cu-Sn), Kupfer-Nickel-Silizium (Cu-Ni-Si) oder Kupfer-Chrom-Silber (Cu-Cr-Ag) enthält. Mittels der Verbindungsmittel 22 wird eine Pressfit-Verbindung hergestellt, über welche das das passiven Bauelement 4 mit der ersten Metallisierung 10 verbunden wird. Durch unterschiedliche mechanische und/oder thermische Eigenschaften, wie Ausdehnungskoeffizient und/oder Elastizitätsmodul, werden beispielsweise während des Betriebes auftretende thermische Verspannungen verringert. Alternativ wird über die Verbindungsmittel 22 eine stoffschlüssige Verbindung zwischen dem passiven Bauelement 4 und der ersten Metallisierung 10 hergestellt. Das weitere Beispiel der Anordnung 2 in FIG 4 entspricht der in FIG 3.

FIG 5 zeigt eine schematische Querschnittsdarstellung einer Ausführungsform einer Anordnung 2 mit einem passiven Bauelement 4 und einem Substrat 6, wobei das passive Bauelement 4 beidseitig jeweils eine erste Profilierung 24 und die erste Metallisierung 10 im Bereich der Kontaktierung mit dem passiven Bauelement 4 jeweils eine zweite Profilierung 26 aufweist. Beispielhaft weist die erste Metallisierung 10 eine Ausnehmung in Form einer Falz auf, wobei das passive Bauelement 4 einen Überstand aufweist, welcher mit der Ausnehmung der ersten Metallisierung 10 in Eingriff steht. Durch die miteinander ein Eingriff stehenden Profilierungen 22, 24 wird eine formschlüssige Verbindung ausgebildet. Zusätzlich oder alternativ weisen die Profilierungen 22, 24 jeweils eine Fase auf. Auf einer der dielektrischen Materiallage 8 abgewandten Seite des Überstands sind jeweils Verbindungsmittel 22, insbesondere Zinnplättchen, angeordnet, welche das passive Bauelement 4 mit der ersten Metallisierung 10 verbinden. Weist die Anordnung 2 Ausgleichsstrukturen 28 zur Kompensation von, insbesondere thermisch bedingten, Ausdehnungen auf. Somit ist das passive Bauelement 4 über eine durch die formschlüssige Verbindung senkrecht zur ersten Oberfläche 20 wirkende Kraft F mit der dielektrischen Materiallage 8 verbunden. Die weitere Ausführung der Anordnung 2 in FIG 5 entspricht der in FIG 4.

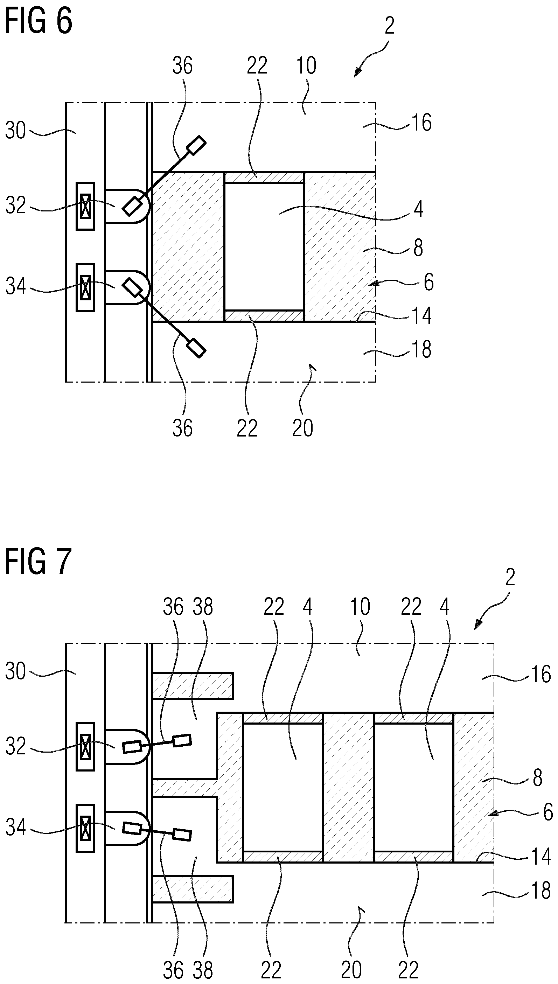

FIG 6 zeigt eine schematische Darstellung eines Ausschnitts eines Beispiels einer Anordnung 2 mit einem passiven Bauelement 4 und einem Substrat 6 in einer Draufsicht. Die Anordnung 2 ist in einem Gehäuse 30 angeordnet und umfasst Anschlüsse 32, 34 zur Kontaktierung des passiven Bauelements 4. Die Anschlüsse 32, 34 sind beispielhaft als Gehäusepins ausgeführt, welche über Bondverbindungsmittel 36, insbesondere Bonddrähte, mit jeweils einer Seite 16, 18 der ersten Metallisierung 10 verbunden sind. Somit wird das passive Bauelement 4 durch die Anschlüsse 32, 34 derartig kontaktiert, dass beispielsweise ein Ermitteln einer am passiven Bauelement 4 abfallenden Spannung oder eines durch das passive Bauelement 4 fließenden Stroms ermöglicht wird. Insbesondere ist das passive Bauelement 4 als NTC-Widerstand zur Verwendung als Temperatursensor ausgeführt, wobei der NTC-Widerstand Platin enthält. Das Beispiel der Anordnung 2 in FIG 6 entspricht der in FIG 4.

FIG 7 zeigt eine schematische Darstellung eines Ausschnitts eines Beispiels einer Anordnung mit einem passiven Bauelement und einem Substrat in einer Draufsicht, wobei beispielhaft zwei passive Bauelemente 4 parallelgeschaltet sind. Die passiven Bauelemente 4 sind beispielhaft als Shunt-Widerstände zur Messung eines Laststroms in einem Leistungshalbleitermodul ausgeführt und sind aus einer Legierung hergestellt, welche Zeranin, Manganin, Konstantan oder Isaohm enthält. Die erste Metallisierung 10 weist auf beiden Seite 16, 18 ein Kontaktpad 38 zur Kontaktierung der Anschlüsse 32, 34 auf. Die Anschlüsse 32, 34 werden über Bondverbindungsmittel 36, insbesondere Bonddrähte, mit den Kontaktpads 38 verbunden. Über die Anschlüsse 32, 34 wird ein Ermitteln eines Spannungsabfalls an den passiven Bauelementen 4, insbesondere zur Ermittlung eines Stromes, ermöglicht. Das Beispiel der Anordnung 2 in FIG 7 entspricht der in FIG 6.

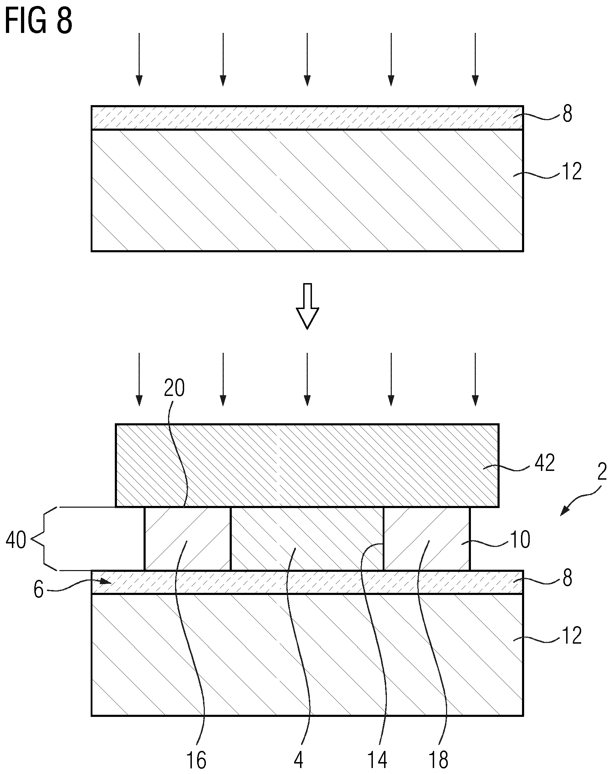

FIG 8 zeigt eine schematische Darstellung eines ersten Verfahrens zur Herstellung einer Anordnung 2 mit einem passiven Bauelement 4 und einem Substrat 6. Eine dielektrische Materiallage 8 wird auf eine zweite Metallisierung 12, welche als Dickkupfersubstrat ausgeführt ist, laminiert. Alternativ wird die dielektrische Materiallage 8 durch Verpressen mit der zweiten Metallisierung 12 verbunden.

In einem weiteren Schritt wird ein passive Bauelement 4 derartig in eine Kavität 44 einer als Dickkupfersubstrat ausgeführten ersten Metallisierung 10 eingebracht und zwischen zwei Seiten 16, 18 der ersten Metallisierung 10 zu einer Top-Lage 40 verbunden. Über eine Pressvorrichtung 42, beispielsweise einen, insbesondere ebenen, Pressstempel, wird die Top-Lage 40 mit der dielektrischen Materiallage 8 derartig verpresst, dass das passive Bauelement 4 vollflächig und unmittelbar auf der dielektrischen Materiallage 8 aufliegt und bündig mit einer ersten Oberfläche 20 der ersten Metallisierung 10 abschließt. Das Verbinden des passiven Bauelements 4 mit der ersten Metallisierung 10 und das Verpressen mit der dielektrischen Materiallage 8 durch die Pressvorrichtung 42 können gleichzeitig stattfinden. Die in FIG 8 gezeigten Schritte sind, insbesondere wenn das Dielektrikum nur einmal aushärtbar ist, in einem Pressvorgang durchführbar. Das Beispiel der Anordnung 2 in FIG 8 entspricht der in FIG 2.

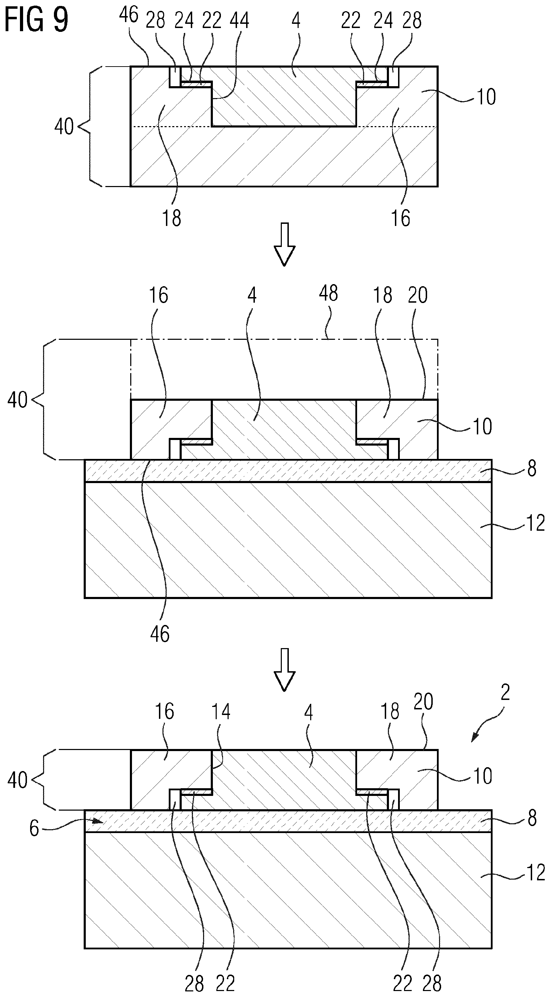

FIG 9 zeigt eine schematische Darstellung eines zweiten Verfahrens zur Herstellung einer Anordnung 2 mit einem passiven Bauelement 4 und einem Substrat 6, wobei das passive Bauelement 4 in eine Kavität 44 der als Dickkupfersubstrat ausgeführten ersten Metallisierung 10 eingebracht und mit der ersten Metallisierung 10 zu einer Top-Lage 40 verbunden wird. Die Kavität 44 der ersten Metallisierung 10 weist auf beiden Seiten 16, 18 eine Ausnehmung in Form einer Falz auf, wobei das passive Bauelement 4 einen Überstand aufweist, welcher mit der Ausnehmung der ersten Metallisierung 10 in Eingriff steht. Wie in FIG 5 gezeigt, ist das passive Bauelement 4 im Bereich seiner beidseitig angeordneten Überstände über Verbindungsmittel 22, insbesondere Zinnplättchen, mit der ersten Metallisierung 10 verbunden und die Anordnung 2 weist Ausgleichsstrukturen 28 zur Kompensation von, insbesondere thermisch bedingten, Ausdehnungen auf. Die Ausgleichsstrukturen 28 sind mit einem Füllmaterial, beispielsweise mit Silikon, gefüllt, um Teilentladungen zu verhindern. Das passive Bauelement 4 schließt bündig mit einer zweiten Oberfläche 46 der ersten Metallisierung 10 ab.

In einem weiteren Schritt wird die Top-Lage 40 über die zweite Oberfläche 46 mit der dielektrischen Materiallage 8 derartig verpresst, dass das passive Bauelement 4 unmittelbar auf der dielektrischen Materiallage 8 aufliegt.

In einem darauffolgenden Schritt wird eine auf einer dem passiven Bauelement 4 abgewandten Seite angeordnete Schicht 48 der ersten Metallisierung 10 mittels spanender Bearbeitung, z.B. durch Fräsen, derartig abgetragen, dass die Kavität 44 zu einer Aussparung 14 in der ersten Metallisierung 10 wird. Ferner wird durch das Abtragen der Schicht 48 das passive Bauelement 4 freigelegt, wobei das das passive Bauelement 4 bündig mit der ersten Oberfläche 20 der ersten Metallisierung 10 abschließt. Die weitere Ausführung der Anordnung 2 in FIG 9 entspricht der in FIG 5.

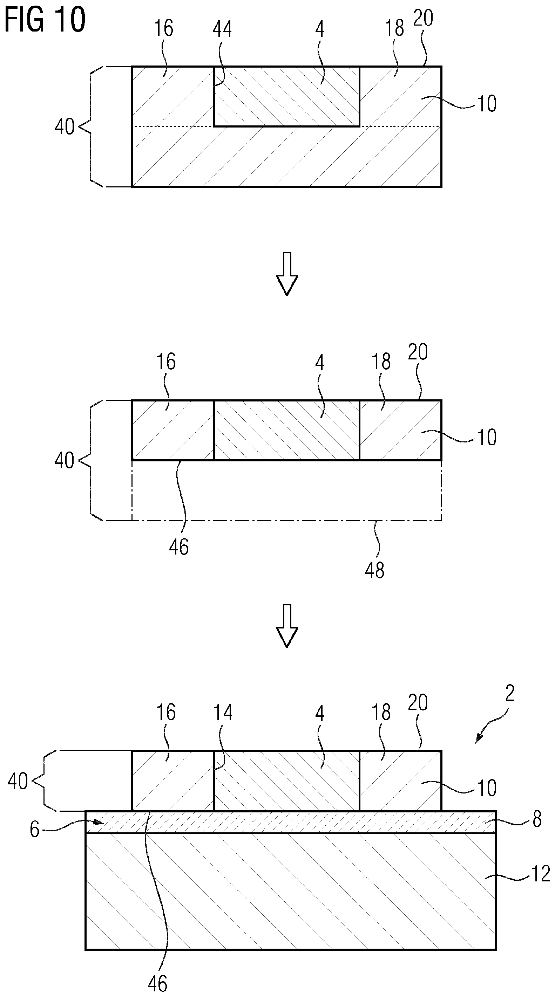

FIG 10 zeigt eine schematische Darstellung eines dritten Verfahrens zur Herstellung einer Anordnung 2 mit einem passiven Bauelement 4 und einem Substrat 6, wobei das passive Bauelement 4 in eine Kavität 44 der als Dickkupfersubstrat ausgeführten ersten Metallisierung 10 eingebracht und mit der ersten Metallisierung 10 zu einer Top-Lage 40 verbunden wird. Beispielsweise ist das passive Bauelement 4, insbesondere durch direktes Verpressen oder durch eine Schrumpfverbindung, kraftschlüssig mit dem Dickkupfersubstrat verbunden. Das passive Bauelement 4 schließt bündig mit der ersten Oberfläche 20 der ersten Metallisierung 10 ab.

In einem weiteren Schritt wird eine auf einer dem passiven Bauelement 4 abgewandten Seite angeordnete Schicht 48 der ersten Metallisierung 10, insbesondere mittels spanender Bearbeitung, derartig abgetragen, dass das passive Bauelement 4 freigelegt wird und das passive Bauelement 4 bündig mit einer zweiten Oberfläche 46 der ersten Metallisierung 10 abschließt.

In einem darauffolgenden Schritt wird der verbleibende Teil der Top-Lage 40 über die zweite Oberfläche 46 mit der dielektrischen Materiallage 8 derartig verpresst, dass das passive Bauelement 4 unmittelbar auf der dielektrischen Materiallage 8 aufliegt. Die weitere Ausführung der Anordnung 2 in FIG 9 entspricht der in FIG 5.

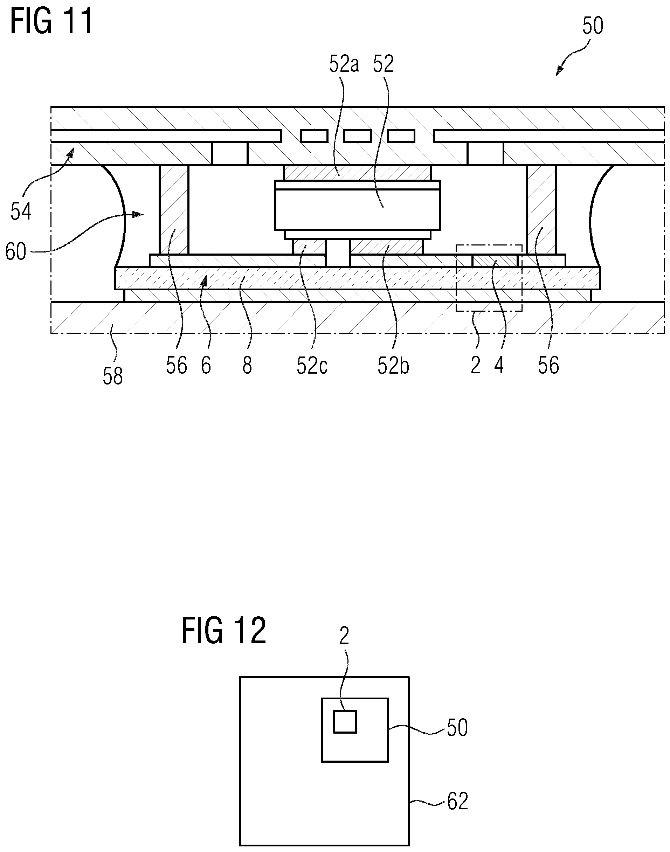

FIG 11 zeigt eine schematische Querschnittsdarstellung einer Halbleiteranordnung 50, welche ein Halbleiterbauelement 52 umfasst, dass mittels planarer Aufbau- und Verbindungstechnik realisiert ist. Das Halbleiterbauelement 52 ist beispielhaft als vertikaler Leistungstransistor, insbesondere als Insulated-Gate-Bipolar-Transistor (IGBT), ausgeführt. Der Leistungstransistor ist über einen ersten Leistungsanschluss 52a mit einer Leiterplatte 54, insbesondere einem Printed Circuit Board (PCB) verbunden. Auf einer dem ersten Leistungsanschluss 52a gegenüberliegenden Seite ist der Leistungstransistor über einen zweiten Leistungsanschluss 52b und einen Steueranschluss 52c mit einem Substrat 6 verbunden, das als DCB-Substrat ausgeführt ist. Über Abstandshalteelemente 56, auch Umsteiger genannt, werden der zweite Leistungsanschluss 52b und der Steueranschluss 52c elektrisch leitend mit der Leiterplatte 54 verbunden. Ferner weist die Halbleiteranordnung 50 eine Anordnung 2 mit einem passives Bauelement 4 auf, welche nach einer der vorherigen Figuren ausgeführt sein kann. Das passives Bauelement 4 ist beispielsweise dazu konfiguriert, einen Strom des zweiter Leistungsanschlusses 52b zu erfassen. Das Substrat 6 ist ferner mit einer Wärmesenke 58, beispielsweise einem Kühlkörper, verbunden, sodass das Halbleiterbauelement 52 und das passives Bauelement 4 elektrisch isolierend und thermisch leitend mit der Wärmesenke 58 verbunden sind. Zwischen der Leiterplatte 54 und dem Substrat 6 ist ein Vergussmaterial 60 angeordnet, in welchem das Halbleiterbauelement 52, die Abstandshalteelemente 56 sowie das das passives Bauelement 4 eingebettet sind. Das Vergussmaterial 60 ist beispielsweise mit Hilfe eines Underfillers gefertigt.

FIG 12 zeigt eine schematische Darstellung eines Stromrichters, welcher beispielhaft eine Halbleiteranordnung 50 mit einer Anordnung 2 umfasst.

Zusammenfassend betrifft die Erfindung eine Anordnung 2 für eine Halbleiteranordnung 50 mit mindestens einem passiven Bauelement 4 und einem Substrat 6, wobei das Substrat 6 eine dielektrische Materiallage 8 und eine auf der dielektrische Materiallage 8 angeordnete erste Metallisierung 10 aufweist. Um den Bauraum der Anordnung 2 zu verringern und eine verbesserte Entwärmung zu ermöglichen, wird vorgeschlagen, dass das passive Bauelement 4 vollständig in einer Aussparung 14 der ersten Metallisierung 10 angeordnet ist und unmittelbar auf der dielektrischen Materiallage 8 aufliegt.

## Patentansprüche

1. Anordnung (2) für eine Halbleiteranordnung (50) mit mindestens einem passiven Bauelement (4) und einem Substrat (6), wobei das Substrat (6) eine dielektrische Materiallage (8) und eine auf der dielektrische Materiallage (8) angeordnete erste Metallisierung (10) aufweist,
wobei das passive Bauelement (4) vollständig in einer Aussparung (14) der ersten Metallisierung (10) angeordnet ist und unmittelbar auf der dielektrischen Materiallage (8) aufliegt,
**dadurch gekennzeichnet, dass**
das passive Bauelement (4) eine erste Profilierung (24) und die erste Metallisierung (10) im Bereich der Kontaktierung mit dem passiven Bauelement (4) eine zweite Profilierung (24) aufweist,
wobei die Profilierungen (24, 26) miteinander im Eingriff stehen.

2. Anordnung (2) nach Anspruch 1,
wobei das passive Bauelement (4) bündig mit einer ersten Oberfläche (20) der ersten Metallisierung (10) abschließt.

3. Anordnung (2) nach einem der Ansprüche 1 oder 2,
wobei die erste Metallisierung (10) als Dickkupfersubstrat ausgeführt ist,
wobei das passive Bauelement (4) zwischen zwei Seiten (16, 18) des Dickkupfersubstrats vollflächig mit der dielektrischen Materiallage (8) verpresst ist.

4. Anordnung (2) nach einem der vorherigen Ansprüche,
wobei das passive Bauelement (4) unmittelbar oder über Verbindungsmittel (22) in der Aussparung (14) der ersten Metallisierung (10) verbunden ist.

5. Anordnung (2) nach Anspruch 4,
wobei das passive Bauelement (4) aus einem ersten Werkstoff hergestellt ist,
wobei die Verbindungsmittel (22) einen zweiten Werkstoff enthalten, welcher sich vom ersten Werkstoff zumindest hinsichtlich seiner mechanischen und/oder thermischen Eigenschaften unterscheidet.

6. Anordnung (2) nach einem der vorherigen Ansprüche,
wobei das passive Bauelement (4) über eine durch die formschlüssige Verbindung senkrecht zur ersten Oberfläche (20) wirkende Kraft (F) mit der dielektrischen Materiallage (8) verbunden ist.

7. Anordnung (2) nach einem der vorherigen Ansprüche,
wobei das Substrat (6) eine zweite Metallisierung (12) aufweist, welche als Dickkupfersubstrat ausgeführt ist,
wobei die dielektrische Materiallage (8) auf die zweite Metallisierung (12) laminiert oder mit der zweiten Metallisierung (12) verpresst ist,
wobei die zweite Metallisierung (12) über die dielektrische Materiallage (8) mit der ersten Metallisierung (10) verbunden ist.

8. Anordnung (2) nach einem der vorherigen Ansprüche,
welche das passive Bauelement (4) als Sensor ausgeführt ist und
wobei die Anordnung (2) zumindest einen Anschluss (32, 34) zur Kontaktierung des Sensors umfasst.

9. Halbleiteranordnung (50), insbesondere planare Halbleiteranordnung, mit mindestens einer Anordnung (2) nach einem der vorherigen Ansprüche.

10. Stromrichter (62) mit mindestens einer Halbleiteranordnung (50) nach dem vorherigen Anspruch.

11. Verfahren zur Herstellung einer Anordnung (2) für eine Halbleiteranordnung (50) mit mindestens einem passiven Bauelement (4) und einem Substrat (6),
wobei das Substrat (6) eine dielektrische Materiallage (8) und eine auf der dielektrische Materiallage (8) angeordnete erste Metallisierung (10) aufweist,
wobei das passive Bauelement (4) vollständig und derartig in einer Aussparung (14) der ersten Metallisierung (10) angeordnet wird, dass das passive Bauelement (4) unmittelbar auf der dielektrischen Materiallage (10) aufliegt,
**dadurch gekennzeichnet, dass**
das passive Bauelement (4) eine erste Profilierung (24) und die erste Metallisierung (10) im Bereich der Kontaktierung mit dem passiven Bauelement (4) eine zweite Profilierung (26) aufweist,
wobei durch die Profilierungen (24, 26) miteinander im Eingriff gebracht werden.

12. Verfahren nach Anspruch 11,
wobei das passive Bauelement (4) derartig in der Aussparung (14) angeordnet wird, dass es bündig mit einer ersten Oberfläche (20) der ersten Metallisierung (10) abschließt.

13. Verfahren nach einem der Ansprüche 11 oder 12,
wobei die erste Metallisierung (10) als Dickkupfersubstrat ausgeführt ist,
wobei das passive Bauelement (4) zwischen zwei Seiten (16, 18) des Dickkupfersubstrats vollflächig mit der dielektrischen Materiallage (8) verpresst wird.

14. Verfahren nach einem der Ansprüche 11 bis 13,
wobei das passive Bauelement (4) unmittelbar oder über Verbindungsmittel (22) in der Aussparung (14) der ersten Metallisierung (10) verbunden wird.

15. Verfahren nach einem der Ansprüche 11 bis 14,
wobei das passive Bauelement (4) in eine Kavität (44) der als Dickkupfersubstrat ausgeführten ersten Metallisierung (10) eingebracht und mit der ersten Metallisierung (10) zu einer Top-Lage (40) verbunden wird,
wobei die Top-Lage (40) mit der dielektrischen Materiallage (8) derartig verpresst wird, dass das passive Bauelement (4) unmittelbar auf der dielektrischen Materiallage (8) aufliegt,
wobei eine auf einer dem passiven Bauelement (4) abgewandten Seite angeordnete Schicht (48) der ersten Metallisierung (10), insbesondere mittels spanender Bearbeitung, derartig abgetragen wird, dass das passive Bauelement (4) freigelegt wird und bündig mit einer ersten Oberfläche (20) der ersten Metallisierung (10) abschließt.

16. Verfahren nach einem der Ansprüche 11 bis 14,
wobei das passive Bauelement (4) derartig in eine Kavität (44) der als Dickkupfersubstrat ausgeführten ersten Metallisierung (10) eingebracht und mit der ersten Metallisierung (10) zu einer Top-Lage (40) verbunden wird, dass das passive Bauelement (4) bündig mit einer ersten Oberfläche (20) der ersten Metallisierung (10) abschließt,
wobei eine auf einer dem passiven Bauelement (4) abgewandten Seite angeordnete Schicht (48) der ersten Metallisierung (10), insbesondere mittels spanender Bearbeitung, derartig abgetragen wird, dass das passive Bauelement (4) freigelegt wird und das passive Bauelement (4) bündig mit einer zweiten Oberfläche (46) der ersten Metallisierung (10) abschließt,
wobei die Top-Lage (40) mit der dielektrischen Materiallage (8) derartig verpresst wird, dass das passive Bauelement (4) unmittelbar auf der dielektrischen Materiallage (8) aufliegt.

17. Verfahren nach einem der Ansprüche 11 bis 16,
wobei das Substrat (6) eine zweite Metallisierung (12) aufweist, welche als Dickkupfersubstrat ausgeführt ist,
wobei die dielektrische Materiallage (8) auf die zweite Metallisierung (12) laminiert oder mit der zweiten Metallisierung (12) verpresst wird.

## Claims

1. Arrangement (2) for a semiconductor arrangement (50) comprising at least one passive component (4) and a substrate (6),
wherein the substrate (6) has a dielectric material layer (8) and a first metallisation (10) arranged on the dielectric material layer (8),
wherein the passive component (4) is arranged completely in a cutout (14) of the first metallisation (10) and bears directly on the dielectric material layer (8),
**characterised in that**
the passive component (4) has a first profile (24) and the first metallisation (10) in the region of contacting with the passive component (4) has a second profile (24),
wherein the profiles (24, 26) engage with one another.

2. Arrangement (2) according to claim 1,
wherein the passive component (4) is flush with a first surface (20) of the first metallisation (10).

3. Arrangement (2) according to one of claims 1 or 2,
wherein the first metallisation (10) is embodied as a thick copper substrate,
wherein the passive component (4) is pressed together with the dielectric material layer (8) over the entire surface between two sides (16, 18) of the thick copper substrate.

4. Arrangement (2) according to one of the preceding claims, wherein the passive component (4) is connected directly or via connection means (22) in the recess (14) of the first metallisation (10).

5. Arrangement (2) according to claim 4,
wherein the passive component (4) is made of a first material, wherein the connection means (22) contain a second material which differs from the first material at least as regards its mechanical and/or thermal properties.

6. Arrangement (2) according to one of the preceding claims, wherein the passive component (4) is connected to the dielectric material layer (8) via a force (F) acting perpendicular to the first surface (20) through the form-fit connection.

7. Arrangement (2) according to one of the preceding claims, wherein the substrate (6) has a second metallisation (12) which is embodied as a thick copper substrate,
wherein the dielectric material layer (8) is laminated onto the second metallisation (12) or is pressed together with the second metallisation (12),
wherein the second metallisation (12) is connected to the first metallisation (10) via the dielectric material layer (8).

8. Arrangement (2) according to one of the preceding claims, wherein the passive component (4) is embodied as a sensor and wherein the arrangement (2) comprises at least one terminal (32, 34) for contacting the sensor.

9. Semiconductor arrangement (50), in particular a planar semiconductor arrangement, comprising at least one arrangement (2) according to one of the preceding claims.

10. Power converter (62) comprising at least one semiconductor arrangement (50) according to the preceding claim.

11. Method for producing an arrangement (2) for a semiconductor arrangement (50) comprising at least one passive component (4) and a substrate (6),
wherein the substrate (6) has a dielectric material layer (8) and a first metallisation (10) arranged on the dielectric material layer (8),
wherein the passive component (4) is arranged completely in a cutout (14) of the first metallisation (10), such that the passive component (4) bears directly on the dielectric material layer (10),
**characterised in that**
the passive component (4) has a first profile (24) and the first metallisation (10) has a second profile (26) in the region of contacting with the passive component (4),
wherein the profiles (24, 26) engage with one another.

12. Method according to claim 11,
wherein the passive component (4) is arranged in the recess (14) such that it is flush with a first surface (20) of the first metallisation (10).

13. Method according to one of claims 11 or 12,
wherein the first metallisation (10) is embodied as a thick copper substrate,
wherein the passive component (4) is pressed together with the dielectric material layer (8) over the entire surface between two sides (16, 18) of the thick copper substrate.

14. Method according to one of claims 11 to 13,
wherein the passive component (4) is connected directly or via connection means (22) in the recess (14) of the first metallisation (10).

15. Method according to one of claims 11 to 14,
wherein the passive component (4) is introduced into a cavity (44) of the first metallisation (10) embodied as a thick copper substrate and is connected to the first metallisation (10) to form a top layer (40),
wherein the top layer (40) is pressed together with the dielectric material layer (8) such that the passive component (4) bears directly on the dielectric material layer (8),
wherein a layer (48) of the first metallisation (10) arranged on a side facing away from the passive component (4) is removed, in particular by machining, such that the passive component (4) is exposed and is flush with a first surface (20) of the first metallisation (10).

16. Method according to one of claims 11 to 14,
wherein the passive component (4) is introduced into a cavity (44) of the first metallisation (10) embodied as a thick copper substrate and is connected to the first metallisation (10) to form a top layer (40), such that the passive component (4) is flush with a first surface (20) of the first metallisation (10),
wherein a layer (48) of the first metallisation (10) arranged on a side facing away from the passive component (4) is removed, in particular by machining, such that the passive component (4) is exposed and the passive component (4) is flush with a second surface (46) of the first metallisation (10),
wherein the top layer (40) is pressed together with the dielectric material layer (8) such that the passive component (4) bears directly on the dielectric material layer (8).

17. Method according to one of claims 11 to 16,
wherein the substrate (6) has a second metallisation (12), which is embodied as a thick copper substrate,
wherein the dielectric material layer (8) is laminated onto the second metallisation (12) or is pressed together with the second metallisation (12).

## Revendications

1. Agencement (2) pour un agencement (50) à semiconducteur comprenant au moins un composant (4) passif et un substrat (6), dans lequel le substrat (6) a une couche (8) de matériau diélectrique et une première métallisation (10) disposée sur la couche (8) de matériau diélectrique,
dans lequel le composant (4) passif est disposé entièrement dans un évidement (14) de la première métallisation (10) et s'applique directement à la couche (8) de matériau diélectrique,
**caractérisé en ce que**
le composant (4) passif a un premier profilage (24) et la première métallisation (10) a, dans la partie de la mise en contact avec le composant (4) passif, un deuxième profilage (24),
dans lequel les profilages (24, 26) sont en prise l'un avec l'autre.

2. Agencement (2) suivant la revendication 1,
dans lequel le composant (4) passif est à affleurement avec une première surface (20) de la première métallisation (10).

3. Agencement (2) suivant l'une des revendications 1 ou 2,
dans lequel la première métallisation (10) est réalisée sous la forme d'un substrat en cuivre épais,
dans lequel le composant (4) passif est comprimé sur toute la surface avec la couche (8) de matériau diélectrique entre deux faces (16, 18) du substrat en cuivre épais.

4. Agencement (2) suivant l'une des revendications précédentes, dans lequel le composant (4) passif est relié directement ou par l'intermédiaire de moyens (22) de liaison dans l'évidement (14) de la première métallisation (10).

5. Agencement (2) suivant la revendication 4,
dans lequel le composant (4) passif est en un premier matériau, dans lequel les moyens (22) de liaison contiennent un deuxième matériau, qui au moins en ce qui concerne ses propriétés mécaniques et/ou thermiques est différent du premier matériau.

6. Agencement (2) suivant l'une des revendications précédentes, dans lequel le composant (4) passif est relié à la couche (8) de matériau diélectrique par une force (F) s'appliquant par la liaison à complémentarité de forme perpendiculairement à la première surface (20).

7. Agencement (2) suivant l'une des revendications précédentes, dans lequel le substrat (6) a une deuxième métallisation (12), qui est réalisée sous la forme d'un substrat en cuivre épais,
dans lequel la couche (8) de matériau diélectrique est laminée sur la deuxième métallisation (12) ou est comprimée avec la deuxième métallisation (12),
dans lequel la deuxième métallisation (12) est reliée à la première métallisation (10) par la couche (8) de matériau diélectrique.

8. Agencement (2) suivant l'une des revendications précédentes, dans lequel le composant (4) passif est réalisé sous la forme d'un capteur, et
dans lequel l'agencement (2) comprend au moins une borne (32, 34) pour la mise en contact du capteur.

9. Agencement (50) à semiconducteur, en particulier agencement à semiconducteur plan, comprenant au moins un agencement (2) suivant l'une des revendications précédentes.

10. Convertisseur (62) ayant au moins un agencement (50) à semiconducteur suivant la revendication précédente.

11. Procédé de fabrication d'un agencement (2) pour un agencement (50) à semiconducteur, comprenant au moins un composant (4) passif et un substrat (6),
dans lequel le substrat (6) a une première couche (8) de matériau diélectrique et une première métallisation (10) disposée sur la couche (8) de matériau diélectrique,
dans lequel le composant (4) passif est disposé entièrement et de telle façon dans un évidement (14) de la première métallisation (10) que le composant (4) passif s'applique directement à la couche (10) de matériau diélectrique,
**caractérisé en ce que**
le composant (4) passif a un premier profilage (24) et la première métallisation (10) a, dans la partie de la mise en contact avec le composant (4) passif, un deuxième profilage (26),
dans lequel les profilages (24, 26) sont en prise l'un avec l'autre.

12. Procédé suivant la revendication 11,
dans lequel le composant (4) passif est disposé dans l'évidement (14), de manière à être à affleurement avec une première surface (20) de la première métallisation (10).

13. Procédé suivant l'une des revendications 11 ou 12,
dans lequel la première métallisation (10) est réalisée sous la forme d'un substrat en cuivre épais,
dans lequel on comprime le composant (4) passif entre deux faces (16, 18) du substrat en cuivre épais à pleine surface avec la couche (8) de matériau diélectrique.

14. Procédé suivant l'une des revendications 11 à 13,
dans lequel on relie le composant (4) passif directement ou par des moyens (22) de liaison dans l'évidement (14) de la première métallisation (10).

15. Procédé suivant l'une des revendications 11 à 14,
dans lequel on introduit le composant (4) passif dans une cavité (44) de la première métallisation (10) réalisée sous la forme d'un substrat en cuivre épais et on le relie à la première métallisation (10) en une couche (40) de sommet,
dans lequel on comprime la couche (40) de sommet avec la couche (8) de matériau diélectrique, de manière à appliquer le composant (4) passif directement sur la couche (8) de matériau diélectrique, dans lequel on retire, en particulier au moyen d'un usinage avec enlèvement de copeaux, une couche (48), disposée sur la face non tournée vers le composant (4) passif, de la première métallisation (10), de manière à ce que le composant (4) passif soit mis à nu et soit à affleurement avec une première surface (20) de la première métallisation (10).

16. Procédé suivant l'une des revendications 11 à 14,
dans lequel on introduit le composant (4) passif dans une cavité (44) de la première métallisation (10) réalisée sous la forme d'un substrat en cuivre épais et on le relie à la première métallisation (10) en une couche (40) de sommet, de manière à ce que le composant (4) passif soit à affleurement avec une première surface (20) de la première métallisation (10),
dans lequel on retire, en particulier au moyen d'un usinage avec enlèvement de copeaux, une couche (48), disposée du côté non tourné du composant (4) passif, de la première métallisation (10), de manière à ce que le composant (4) passif soit mis à nu et de manière à ce que le composant (4) passif soit à affleurement avec une deuxième surface (46) de la première métallisation (10),
dans lequel on comprime la couche (40) de sommet avec la couche (8) de matériau diélectrique, de manière à appliquer le composant (4) passif directement sur la couche (8) de matériau diélectrique.

17. Procédé suivant l'une des revendications 11 à 16,
dans lequel le substrat (6) a une deuxième métallisation (12), qui est réalisée sous la forme d'un substrat en cuivre épais,
dans lequel on lamine la couche (8) de matériau électrique sur la deuxième métallisation (12) et on la comprime avec la deuxième métallisation (12).
